# EUROPEAN PATENT SPECIFICATION

(11) **EP 0 338 455 B1**
(45) Date of publication and mention of the grant of the patent: **20.07.1994**
(21) Application number: 89106736.5
(22) Date of filing: 14.04.1989
(51) Int. Cl.: G11C 29/00, G07G 1/00

(54) **Elektronische Registrierkasse mit Speicherdefekterkennung**
Electronic cash register with memory defect judging means
Caisse électronique avec des moyens pour détecter des défauts dans la mémoire de la caisse

(30) Priority: 16.04.1988 JP 94324/88
(43) Date of publication of application: 25.10.1989
(73) Proprietor: SHARP KABUSHIKI KAISHA, Osaka 545 (JP)
(72) Inventor: Ikoma, Keiichi, Nara-shi Nara-ken (JP)
(74) Representative: TER MEER STEINMEISTER & PARTNER GbR

(56) References cited:
- FR-A- 2 414 755
- PATENT ABSTRACTS OF JAPAN, vol. 6, no. 30 (P-103)[908], 23rd February 1982;& JP-A-56 148 796
- PATENT ABSTRACTS OF JAPAN, vol. 4, no. 103, (P-20)[585], 23rd July 1980;& JP-A-55 62 600

## Description

### BACKGROUND OF THE INVENTION

### 1. Field of the Invention

The present invention relates to an electronic cash register for which is required that its memory content is correctly maintained even when its power supply is cut off.

### 2. Description of the Prior Art

Patent Abstracts of Japan, Vol. 4, No. 103 (P-20) [585], 23.7.1980 (Abstract for JP-A-55-62600) describes a constitution comprising
- a ROM storing inspection data, other data, an inspection program and other programs;
- a RAM comprising an inspection data region and a region for other data; and
- defect judging means using said inspection program for judging that said RAM is defective when the content of its inspection data region does not coincide with said inspection data as stored in said ROM.

### SUMMARY OF THE INVENTION

It is the object of the present invention to provide a very reliable electronic cash register.

The electronic cash register of the invention is defined by the features of claim 1. Its RAM is composed of a plurality of RAM-chips, each comprising an inspection data region and a region for other data. The inspection data region is used for a comparison as discussed above in relation with the prior art. As soon as the defect judging means judges, when performing such a comparison, that the just investigated RAM-chip is defective, it sets aside this defective RAM-chip so that it is not used in arithmetic processings.

Preferably, the defect judging means is arranged to perform the above comparison in a master reset processing operation for a plurality of times, as long till the comparison is successful or till a predetermined number of repeated trials is reached without having had success.

Due to these functions, the electronic cash register of the present invention can be operated very reliably.

### BRIEF DESCRIPTION OF THE DRAWINGS

These and other objects of the invention, as well as the features and advantages thereof, will be better understood and appreciated from the following detailed description taken in conjunction with the drawings, in which:
FIG. 1 is a block diagram showing a basic structure of an ECR 1 in an embodiment of the invention;
FIG. 2 is a plan view showing a key layout of a key input unit 3;
FIG. 3 is a flow chart for explaining the operation of a control unit 2 for master reset processing; and
FIG. 4 is a flow chart for explaining the power ON processing to be done in the control unit 2 when the power source is supplied again after once being cut off.

### DETAILED DESCRIPTION OF THE PREFERRED EMBODIMENTS

Referring now to the drawings, preferred embodiments of the invention are described in details below.

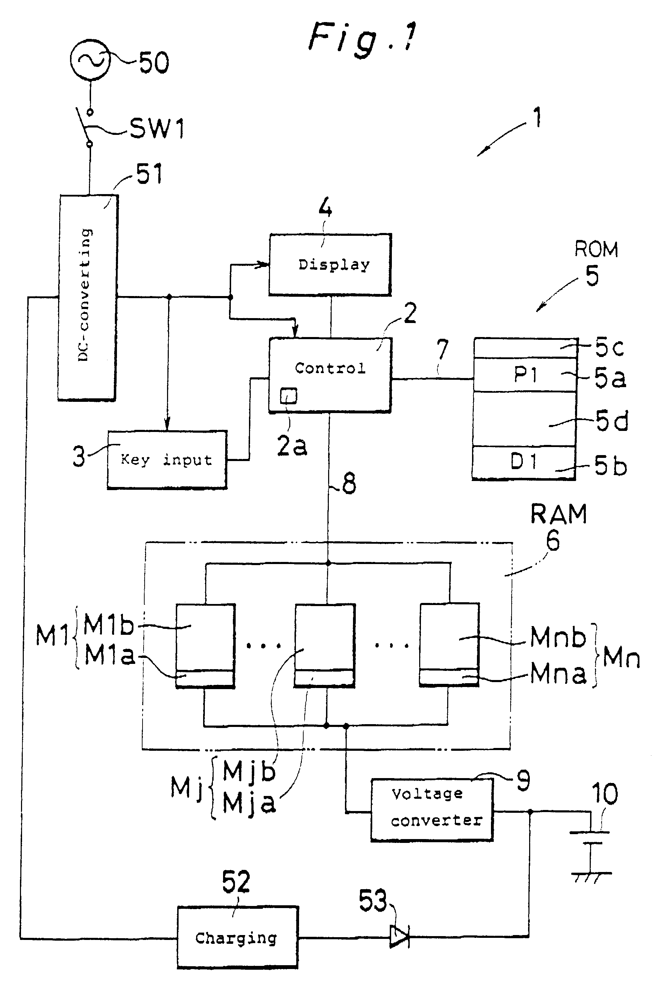

FIG. 1 is a block diagram showing a basic structure of an electronic cash register (ECR) 1 according to an embodiment of the invention. The ECR 1 possesses a control unit 2 which comprises, for example, a central processing unit (CPU) and others, and a key input unit 3 and a display unit 4 are connected to this control unit 2. The operator, by manipulating the key input unit 3 while observing the display unit 4, can enter the data relating to the cash registration, for example, the name of the merchandise purchased by the customer and its quantity, and can also instruct various arithmetic processings.

To the control unit 2 are also connected a read-only memory (ROM) 5 which is a first memory device and a random access memory (RAM) 6 which is a second memory device, by way of bus lines 7, 8, respectively.

In the ROM 5, the operation program of the control unit 2 is stored in predetermined memory regions 5c, 5d, and program P1 for the power ON processing mentioned later, and data for inspection D1 mentioned later are stored in predetermined memory regions 5a, 5b. The RAM 6 is composed of n RAM chips M1 to Mn realized by, for example, C-MOS (complementary-metal oxide semiconductor) integrated circuit elements and others, and these RAM chips M1 to Mn are connected to the bus line 8. To such RAM 6, a battery 10 for backup is connected through a voltage converter circuit 9. The battery 10 is a secondary cell.

The ECR 1 is energized by a commercial AC power source 50. That is, the voltage from the commercial AC power source 50 supplied through a switch SW1 is converted into a direct-current voltage by a DC converting circuit 51, and is applied to the control unit 2, key input unit 3 and display unit 4. The output from the DC converting circuit 51 is given to a charging circuit 52. In the control unit 2, a detecting part 2a for detecting the supply of power source is disposed.

While the ECR 1 is energized, a supply voltage is applied to the battery 10 by the charging circuit 52 through a diode 53, and therefore the battery 10 is charged. While the power source of the ECR 1 is cut off, the voltage from the battery 10 is applied to RAM chips M1 to Mn in the RAM 6 through the voltage converter circuit 9, so that the memory content in the RAM 6 is maintained.

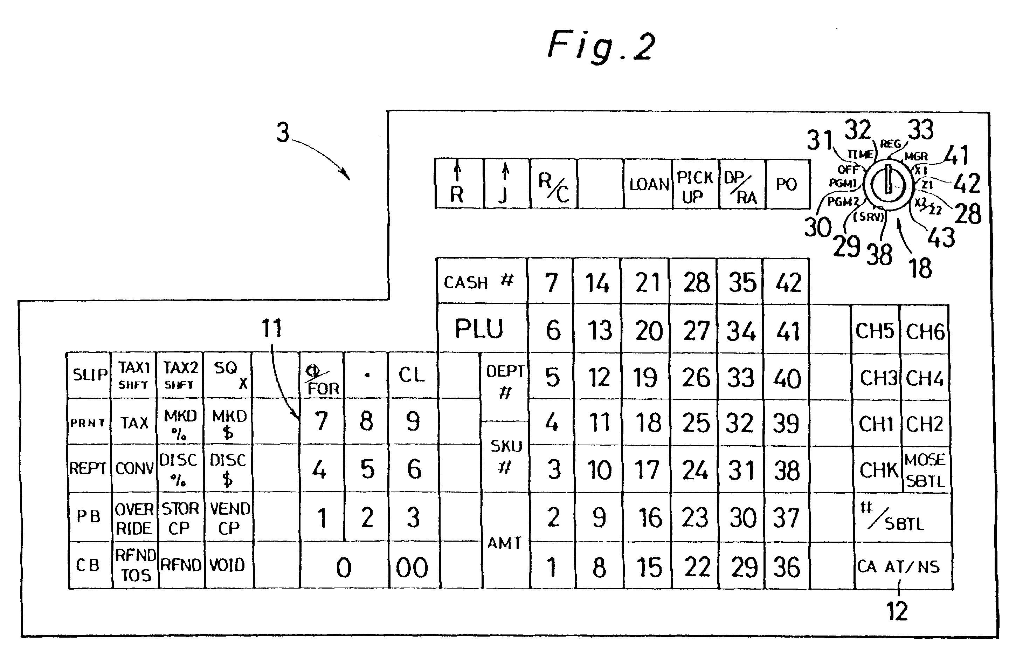

FIG. 2 shows the layout of keys in the key input unit 3 for performing the cash registration operations in the ECR 1 shown in FIG. 1 at, for example, the shop counter. The key input unit 3 has plural operation keys, comprising numeric keys 11 for entering the cash information or the like, and a CA (total) key 12 for calculating the total of transactions for each customer.

Near the key input unit 3, there is a mode selector 18. By inserting a key (not shown) into a key hole 28 in the mode selector 18 and dislocating angularly, program operation positions 29, 30 for changing the information such as the name of the merchandise stored in the RAM 6, power cutoff position 31, clock function position 32, cash registration operation position 33, checking positions 41, 42, 43 for reading or resetting in daily total or monthly total, and maintenance operation position 38 may be selectively specified, and the ECR 1 can be set in the operating state corresponding to such operation positions.

In the key hole 28, generally, plural types of key can be inserted. However, the range of angular dislocation in the mode selector 18 is individually for each type of key, and for example the key for turning up to the maintenance operation position 38 is held by a serviceman responsible for the maintenance of the ECR 1. When the power is supplied into the ECR 1 with the key turned up to the maintenance operation position 38 in the key hole 28, the "master reset process" mentioned later will be effected.

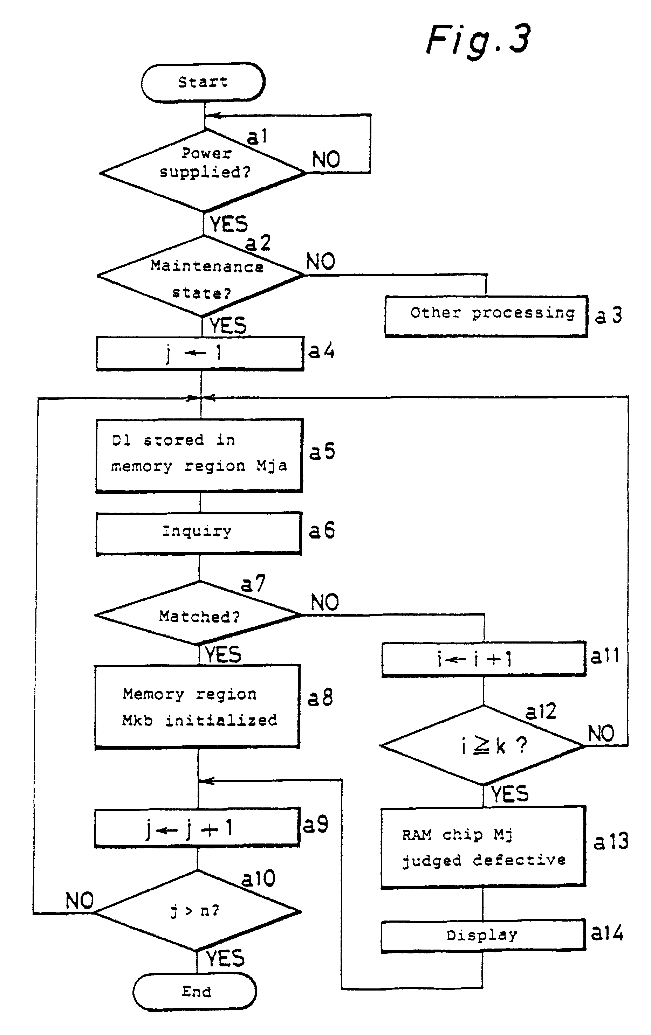

FIG. 3 is a flow chart for explaining the operation of the control unit 2 in master reset processing. The master reset processing operation is effected in the state of shipping from the shop in which the ECR 1 is fabricated, and also effected, as required, by the serviceman. By the master reset processing, the entire system of the ECR 1 is initialized, including clearing of the memory content in the RAM 6. The master reset processing is executed in the maintenance state, with the key inserted in the key hole 28 being turned and set in the maintenance operation position 38.

At step a1, when the supply of power is detected by the detecting part 2a, the operation advances to step a2 to judge whether the maintenance state is set or not. If not set in the maintenance state, the operation goes to step a3, and the next processing is done. If set in the maintenance state, the operation jumps to step a4, and the RAM chip number "j" is set in "1."

At step a5, the data for inspection D1 stored in the memory region 5b in the ROM 5 is read out. This data for inspection D1 is fed into the RAM 6 through the bus line 8. The data for inspection D1 is stored in a predetermined memory region Mja of the j-th RAM chip Mj in the RAM 6.

At step a6, the memory content in the memory region Mja in the j-th RAM chip Mj is read out, and is collated with the data for inspection D1 stored in the memory region 5b of the ROM 5.

At step a7, it is judged whether the memory content in the memory region Mja and the data for inspection D1 are matched or not. If matched, that is, when it is judged that the data for inspection D1 is correctly written into the RAM chip Mj, the operation advances to step a8.

At step a8, the memory content in the remaining memory region Mjb in the j-th RAM chip Mj is cleared, and other initialization process is done.

At step a9, the RAM chip number "j" is incremented, and at step a10, it is judged whether the RAM chip number "j" has reached the total RAM chip number "n" of the RAM 6 or not, and when achieving the number "n," this master reset operation is terminated.

At the foregoing step a7, if the content stored in the RAM chip Mj and the data for inspection D1 are not matched, that is, when the data for inspection D1 is not correctly written in the RAM chip Mj, the operation advances to step all, and the parameter i showing the number of times of writing the data for inspection D1 in the RAM 6 is incremented.

At step a12, it is judged whether the parameter i is over the predetermined constant k or not. If the parameter i is less than the constant k, the operation returns to step a5, and when the parameter i reaches the constant k, the operation advances to step a13.

At step a13, it is judged that the j-th RAM chip Mj is defective.

At step a14, the fact that the j-th RAM chip Mj is defective is indicated in the display unit 4.

In this way, the data for inspection D1 is written in the RAM chips M1 to Mn in the RAM 6, and the data for inspection D1 is held in the memory regions M1a to Mna as far as defect of RAM chips M1 to Mn, trouble of voltage converter 9 or consumption of battery 10 should not occur.

When the RAM chips M1 to Mn in the RAM 6 are individually composed, the RAM chip judged to be defective is set aside so as not to be used in arithmetic processing of the ECR 1.

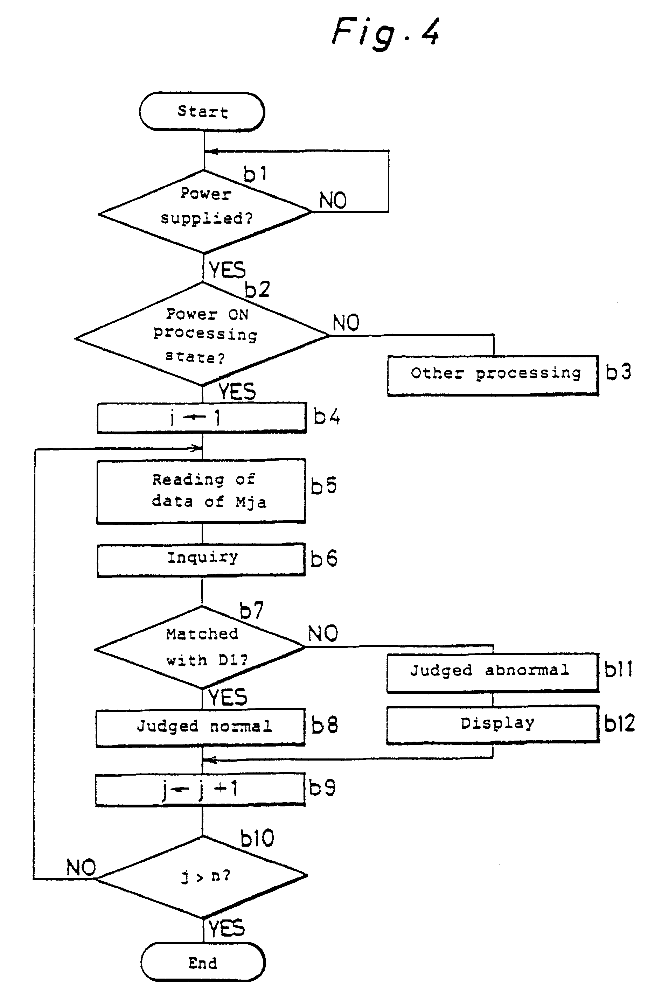

FIG. 4 is a flow chart for explaining the power ON processing carried out in the control unit 2. The power ON processing is conducted by turning the key inserted into the key hole 28 to angularly dislocate the power cutoff position 31 to, for example, the cash registration operation position 33 to turn on the power source.

When the supply of power is detected at step b1, the operation advances to step b2, and it is judged whether the predetermined operating state for power ON processing, such as the cash registration operating state, is set or not. If not set in such operating state, the operation advances to step b3, and other processing is done. If set in this operating state, the operation advances to step b4.

At step b4, the RAM chip number "j" is set to "1."

At step b5, the memory content in the memory region Mja of RAM chip Mj (j=1) is read out.

At step b6, the data for inspection D1 stored in the memory region 5b of the ROM 5 is read out, and is collated with the data read out from the RAM chip Mj. At step b7, it is judged whether the both are matched or not. If matched, the operation advances to step b8.

At step b8, it is judged that the data holding function of the j-th RAM chip Mj is working normally.

At step b9, the RAM chip number "j" is incremented, and at step b10, it is judged whether the RAM chip number "j" has reached the total RAM chip number "n" in the RAM 6 or not, and if not, the operation returns to step b5, and if yes, this power ON processing operation is terminated.

At step b7, if the two sets of data are not matched, the operation jumps to b11, and it is judged that the data holding function of the RAM chip Mj is not working normally, and this fact is indicated in the display unit at step b12. Thereafter, the operation goes to step b9.

Such power ON processing is effected, for example, every time the cash registration action is done, that is, every time the power source is turned on, and it means that the data holding function of the RAM 6 is inspected every time in operating the ECR 1. Therefore, the cash information entered by the operation of the key input unit 3 after such inspection is securely held in the RAM 6 even after the power source is cut off. That is, since the data is fed into the RAM 6 after making sure that the data holding function of the RAM 6 is normal, unexpected erasure of data may be securely prevented.

## Claims

1. An electronic cash register comprising:
a) a ROM (5) storing inspection data, other data, an inspection program and other programs;
b) a RAM (6) composed of a plurality of RAM-chips, each comprising an inspection data region (Mja) and a region (Mjb) for other data; and
c) a defect judging means (2) using said inspection program for judging that one of the RAM-chips is defective, when the content of its inspection data region does not coincide with said inspection data as stored in said ROM, and for setting aside the defective RAM-chip so that it is not used in arithmetic processings.

2. An electronic cash register according to claim 1, wherein said defect judging means (2) is arranged to perform a master reset processing operation in which
i) it writes data into the inspection data region (Mja) of a RAM-chip;
ii) it judges whether the data read from said inspection data region coincide with inspection data as stored in said ROM (5);
iii) it repeats steps i and ii provided that the compared data do not coincide; and
iv) it judges the inspected RAM-chip as being defective when it repeated step iii for a predetermined number of times without coincidence of the compared data.

## Patentansprüche

1. Elektronische Registrierkasse mit:
a) einem ROM (5), der Prüfdaten, andere Daten, ein Prüfprogramm und andere Programme speichert;
b) einem RAM (6), der aus mehreren RAM-Chips besteht, von denen jedes einen Prüfdatenbereich (Mja) und einen Bereich (Mjb) für andere Daten aufweist; und
c) einer Defekterkennungseinrichtung (2), die das genannte Prüfprogramm dazu verwendet, zu erkennen, daß einer der RAM-Chips fehlerhaft ist, wenn der Inhalt seines Prüfdatenbereichs nicht mit den im RAM abgespeicherten Prüfdaten übereinstimmt, und zum Ausklammern des fehlerhaften RAM-Chips, so daß er bei arithmetischen Verarbeitungen nicht verwendet wird.

2. Elektronische Registrierkasse nach Anspruch 1, bei der die genannte Defekterkennungseinrichtung (2) so ausgebildet ist, daß sie einen Hauptrücksetz-Verarbeitungsvorgang ausführt, bei dem
i) sie Daten in den Prüfdatenbereich (Mja) eines RAM-Chips einschreibt;
ii) sie beurteilt, ob die aus dem Prüfdatenbereich ausgelesenen Daten mit den im ROM (5) abgespeicherten Prüfdaten übereinstimmen;
iii) sie die Schritte i und ii wiederholt, wenn die verglichenen Daten nicht übereinstimmen; und
iv) sie den überprüften RAM-Chip als fehlerhaft beurteilt, wenn sie den Schritt iii eine vorgegebene Anzahl von Malen ohne Übereinstimmung der verglichenen Daten wiederholte.

## Revendications

1. Une caisse enregistreuse électronique comprenant:
a) une ROM (5) mémorisant des données d'inspection, d'autres données, un programme d'inspection et d'autres programmes ;
b) une RAM (6) composée de différentes puces de RAM, chacune comprenant une zone (Mja) de données d'inspection, et une zone (Mjb) pour d'autres données; et
c) un moyen (2) de jugement de défaut utilisant ledit programme d'inspection pour juger qu'une des puces de RAM est défectueuse lorsque le contenu de sa zone de données d'inspection ne coïncide pas avec ladite donnée d'inspection mémorisée dans ladite ROM, et pour mettre hors service la puce de RAM défectueuse, afin qu'elle ne soit pas utilisée dans les traitements arithmétiques.

2. Une caisse enregistreuse électronique, selon la revendication 1, dans laquelle le dit moyen (2) de jugement de défaut est conçu pour effectuer une opération générale de remise à zéro dans laquelle:
i) il écrit des données dans la zone (Mja) de données d'inspection d'une puce de RAM ;
ii) il juge si les données lues à partir de la dite zone de données d'inspection, coïncident avec les données d'inspection mémorisées dans la dite ROM (5) ;
iii) il répète les étapes i et ii, si les données comparées ne coïncident pas; et
iv) il juge la puce de RAM inspectée comme étant défectueuse lorsqu'elle a répété l'étape iii pendant un nombre de fois prédéterminé, sans coïncidence des données comparées.
